# EUROPEAN PATENT SPECIFICATION

(11) **EP 4 407 867 B1**
(45) Date of publication and mention of the grant of the patent: **13.08.2025**
(21) Application number: 24153335.5
(22) Date of filing: 23.01.2024
(51) Int. Cl.: H03F 1/56, H03F 3/183, H03F 3/21

(54) **IMPEDANCE ADAPTATION CIRCUIT, AUDIO PROCESSING APPARATUS AND IN-VEHICLE INFOTAINMENT SYSTEM**
IMPEDANZANPASSUNGSSCHALTUNG, AUDIOVERARBEITUNGSVORRICHTUNG UND FAHRZEUGINTERNES INFOTAINMENTSYSTEM
CIRCUIT D'ADAPTATION D'IMPÉDANCE, APPAREIL DE TRAITEMENT AUDIO ET SYSTÈME D'INFODIVERTISSEMENT EMBARQUÉ

(30) Priority: 28.01.2023 CN 202310079586
(43) Date of publication of application: 31.07.2024
(73) Proprietor: Harman International Industries, Incorporated, Stamford, Connecticut 06901 (US)
(72) Inventor: SHEN, Ebing, Shenzhen, 518067 (CN)
(74) Representative: Rummler, Felix

(56) References cited:
- CN-U- 204 836 547
- JP-A- 2011 251 626
- US-A1- 2013 294 609

## Description

### Technical Field

The present disclosure relates to an impedance adaptation circuit, an audio processing apparatus and an in-vehicle infotainment system.

### Background

With the development of technology, today's in-vehicle infotainment (IVI) systems have covered functions such as navigation, music, video, phone calls, and information interaction. For example, a head unit of one in-vehicle infotainment system can amplify an audio signal through its built-in audio power amplifier to drive speakers installed on the vehicle to emit sound, thereby achieving music playing or voice output.

Under normal circumstances, using the built-in audio power amplifier of the head unit to directly drive the speakers can meet basic sound output needs. However, as the listening experience requirements for in-vehicle entertainment content continue to increase, people may not be satisfied with the performance of the built-in audio power amplifier in an original in-vehicle audio system. In order to improve the user experience, in the aftermarket, an external audio processing circuit can be installed on the basis of the built-in audio power amplifier. However, how to ensure the normal start-up and operation of an in-vehicle audio system while adding an external audio processing circuit to a head unit is a challenging problem. The following documents: CN204836547U, JP2011251626A and US2013/294609A1 are considered to disclose relevant prior art teachings.

### Summary

According to one aspect of the present disclosure, an impedance adaptation circuit is provided, which is used for being connected between a head unit and an audio processing circuit, wherein the impedance adaptation circuit includes an adaptation resistor and a switching element; a first end of the adaptation resistor is connected to a first audio output end of the head unit and a first audio input end of the audio processing circuit; a second end of the adaptation resistor is connected to a first end of the switching element; a second end of the switching element is connected to a second audio output end of the head unit and a second audio input end of the audio processing circuit; the adaptation resistor has a resistance value within a matched working impedance range of the head unit; and the switching element is configured to be in an on state during start-up load diagnostic of the head unit and switch off after the start-up load diagnostic is completed.

According to another aspect of the present disclosure, an audio processing apparatus is provided. The audio processing apparatus includes the impedance adaptation circuit provided by the present disclosure and an audio processing circuit.

According to yet another aspect of the present disclosure, an in-vehicle infotainment system is provided. The in-vehicle infotainment system includes: a head unit; the impedance adaptation circuit provided by the present disclosure; an audio processing circuit; and a speaker, connected to an output of the audio processing circuit.

### Brief Description of the Drawings

Aspects, features and advantages of the present disclosure will become clearer and easier to understand through the following description of the embodiments in conjunction with the accompanying drawings, in which:
FIG. 1 is a schematic diagram of an example of an exemplary circuit of an in-vehicle infotainment system.
FIG. 2 is a schematic diagram of another example of an exemplary circuit of an in-vehicle infotainment system.
FIG. 3 is a circuit schematic of an example of an in-vehicle infotainment system with an adaptation resistor.
FIG. 4 to FIG. 8 are circuit schematics of an example of an in-vehicle infotainment system with an impedance adaptation circuit according to one or more embodiments of the present disclosure.

To facilitate understanding, the same or similar reference numbers are used throughout the drawings to designate the same or similar elements, circuits, or apparatuses in the drawings.

### Detailed Description

The present disclosure will be described in detail below with reference to exemplary embodiments of the present disclosure. However, the present disclosure is not limited to the embodiments described herein, but may be implemented in many different forms. The described embodiments are merely intended to make the present disclosure thorough and complete, and to fully convey the concept of the present disclosure to those skilled in the art. Features of the various embodiments described may be combined with or substituted for each other unless expressly excluded or should be excluded by context.

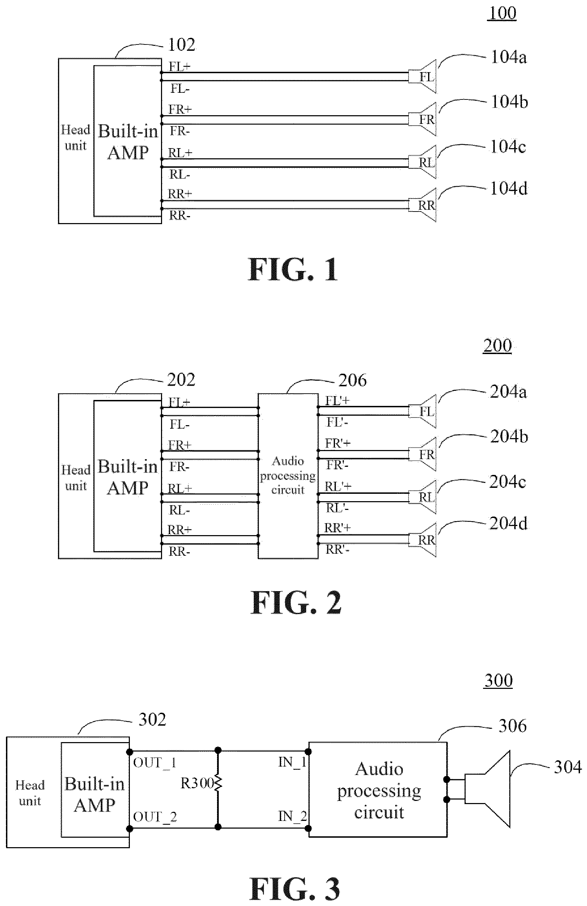

In order to facilitate understanding of the working principle of the impedance adaptation circuit of the present disclosure, examples of an in-vehicle infotainment system are first described with reference to FIG. 1 to FIG. 2.

FIG. 1 is a circuit schematic of an example of an in-vehicle infotainment system. As shown in FIG. 1, a head unit 102 of an in-vehicle infotainment system 100 may include a built-in audio power amplifier (AMP), which is used to amplify an audio signal provided by a front stage of the head unit 102 to provide an amplified audio signal to a speaker 104. In the example of FIG. 1, the in-vehicle infotainment system 100 may include four speakers installed on front and rear doors, such as a front left FL speaker 104a, a front right FR speaker 104b, a rear left RL speaker 104c, and a rear right RR speaker 104d. Correspondingly, the built-in AMP can provide 4-channel audio signals to the corresponding 4 speakers, such as audio signals FL+ and FL- of a first channel, audio signals FR+ and FR- of a second channel, audio signals RL+ and RL- of a third channel, and audio signals RR+ and RR- of a fourth channel.

FIG. 2 is a circuit schematic of another example of an in-vehicle infotainment system. As shown in FIG. 2, in an in-vehicle infotainment system 200, an audio processing circuit 206 can be added to a head unit 202 to improve the performance of the original audio system (such as its built-in AMP) of the in-vehicle infotainment system. Similar to what is described with reference to FIG. 1, the built-in AMP of the head unit 202 can provide 4-channel audio signals, such as FL+ and FL-, FR+ and FR-, RL+ and RL-, and RR+ and RR-. Similarly, the audio processing circuit 206 may also include a 4-channel audio processing unit to perform audio enhancement processing on the 4-channel audio signals provided by the head unit 202 so as to provide enhanced audio signals FL'+ and FL'-, FR'+ and FR'-, RL'+ and RL'-, and RR'+ and RR'-, thereby driving the corresponding speakers 204a-204d.

However, as described above, how to ensure the normal start-up and operation of an in-vehicle audio system while adding an audio processing circuit to a head unit is a challenging problem. Specifically, referring back to FIG. 1, the head unit 102 needs to run a load diagnostic function when started so as to determine a connection status of its speakers, so that the audio signal will be provided to the speakers only after it is determined that there is no abnormalities such as short circuit or open circuit, such that the in-vehicle audio system starts music playing or voice output. For example, the impedance of a speaker is usually only a few ohms, so when the head unit 102 determines that there is an open circuit load of thousands of ohms or a short circuit load close to zero, it can be determined that there is an abnormality. However, when the external audio processing circuit 206 is installed on the head unit 202 as shown in FIG. 2, since an input impedance of the audio processing circuit 206 is usually several thousand ohms, the head unit 202 will regard it as an open circuit load during start-up load diagnostic, resulting in the inability to normally start the in-vehicle audio system to achieve sound output.

To address this problem, some head units are configured with an optional line out mode to determine whether the head unit is connected to an external audio processing circuit. In the line out mode, when the head unit detects a load impedance ranging from tens of ohms to several thousand ohms, it can determine the existence of an external audio processing circuit connected to the head unit, thereby starting a mode of providing audio signals to the external audio processing circuit, and then driving the speakers by the external audio processing circuit to perform sound output. However, the line out mode is not a function that all head units are configured with, and the enabling of this mode and its test signals need complex configuration. Another solution is to add an adaptation resistor that matches the head unit between the head unit and the external audio processing circuit, so that the head unit will not detect the installed external audio processing circuit as an open circuit load, which will lead to the failure of load diagnostic, and then it will not be able to provide listening services for occupants in the vehicle normally. The working principle of the latter solution will be described below in conjunction with FIG. 3.

FIG. 3 is a circuit schematic of an example of an in-vehicle infotainment system with an adaptation resistor. As shown in FIG. 3, in an in-vehicle infotainment system 300, a head unit 302 can provide a pair of audio signals to a first audio input end IN_1 and a second audio input end IN_2 of an audio processing circuit 306 through its built-in AMP at a first audio output end OUT_1 and a second audio output end OUT_2. Then, the audio processing circuit 306 may enhance the received audio signals and then drive a speaker 304 to achieve sound output. It can be understood that FIG. 3 takes an output channel from the head unit 302 to the speaker 304 as an example for illustration, and other output channels can adopt the same configuration.

As shown in FIG. 3, the in-vehicle infotainment system 300 may include an adaptation resistor R300 connected between the head unit 302 and the audio processing circuit 306. Specifically, a first end (upper end) of the adaptation resistor R300 is connected to the first audio output end OUT_1 of the head unit 302 and the first audio input end IN_1 of the audio processing circuit 306, and a second end (lower end) of the adaptation resistor R300 is connected to the second audio output end OUT_2 of the head unit 302 and the second audio input end IN_2 of the audio processing circuit 306. In addition, the adaptation resistor R300 has a resistance value within a matched working impedance range of the head unit 302. It can be understood that compared with abnormal conditions such as short circuit loads and open circuit loads, the matched workload of the head unit refers to the impedance range that the head unit can detect assuming that the head unit and the speaker are correctly connected, which corresponds to a matching state that enables the head unit to normally drive the speaker to emit sound. The determination of the resistance value of the adaptation resistor R300 will be described specifically below.

It should be noted that the built-in AMP of the head unit 302 can be implemented using various power amplification chips. Taking the chip model NXP TDF8532 as an example, the chip is internally provided with a start-up load diagnostic function to determine a connection status of its speaker when it is started up and powered on, such as a short circuit load, an open circuit load, or a matched workload, thereby determining whether to provide audio signals to drive the speaker. Specifically, the chip is internally provided with various threshold standards for start-up load diagnostic, as shown in Table 1.

**Table 1 Threshold standards for start-up load diagnostic of head unit**

| Load type | Speaker impedance | Minimum value | Typical value | Maximum value |
|---|---|---|---|---|
| Short circuit load detection threshold | 1-ohm speaker | - | - | 0.2 ohms |
| | 2-ohm speaker | - | - | 0.5 ohms |
| | 4-ohm speaker | - | - | 1.5 ohms |
| Workload detection threshold | 1-ohm speaker | 0.85 ohms | - | 20 ohms |
| | 2-ohm speaker | 1.7 ohms | - | 20 ohms |
| | 4-ohm speaker | 3.2 ohms | - | 20 ohms |
| Open circuit load detection threshold | - | 8000 ohms | - | - |

Combined with Table 1, taking a 2-ohm speaker as an example: when a load calculated based on a voltage applied to both ends of the load and a current flowing through it is close to zero ohm (for example, less than 0.5 ohm), it can be regarded as a short circuit; when the calculated load is within the range of several ohms to dozens of ohms (for example, the lower limit value 1.7 ohms to the upper limit value 20 ohms), it can be regarded as a workload that matches the head unit (that is, it will be determined that the head unit and the speaker are directly connected correctly); and when the calculated load is more than several thousand ohms (for example, more than 8 kilohms), it can be regarded as an open circuit. However, since the input impedance of the audio processing circuit 306 is about several thousand ohms (for example, 10 kilohms), if there is no adaptation resistor R300, the head unit 302 will regard it as an open circuit load, which will result in the inability to start driving the speaker. For this, the adaptation resistor R300 can be set to have a value within the matched workload range of the head unit (e.g., 1.7-20 ohms). Therefore, during the start-up load diagnostic of the head unit 302, even if the head unit 302 is connected to the audio processing circuit 306, due to the parallel effect of the adaptation resistor R300 and the input impedance of the audio processing circuit 306, the head unit 302 will conclude that "the head unit and the speaker are directly connected correctly" without regarding it as a short circuit or open circuit abnormality, thus successfully passing the start-up load diagnostic to achieve music playing or voice output.

Although the above-mentioned adaptation resistor R300 can make it possible to successfully pass the start-up load diagnostic when the external audio processing circuit is installed, however, after the start-up load diagnostic is completed (that is, during the working period that the head unit 302 provides the audio signal to the audio processing circuit 306 and then the audio processing circuit 306 drives the speaker for sound output), the adaptation resistor R300 still receives the audio signal provided by the head unit 302, thus continuously generating power consumption and generating heat that is dissipated to the surrounding environment. For example, in a case that the adaptation resistor R300 is 20 ohms, when an output voltage of the head unit is 10 Vrms, it will consume a power of (10V*10V)/20Ω=5W, and a large package size capable of withstanding 5W power needs to be selected for the adaptation resistor R300. Therefore, although the adaptation resistor R300 can solve the problem of being unable to pass the start-up load diagnostic after installing the external audio processing circuit to a certain extent, it will still generate unnecessary power consumption and heat after the start-up load diagnostic process is completed, and a large circuit packaging area will be occupied.

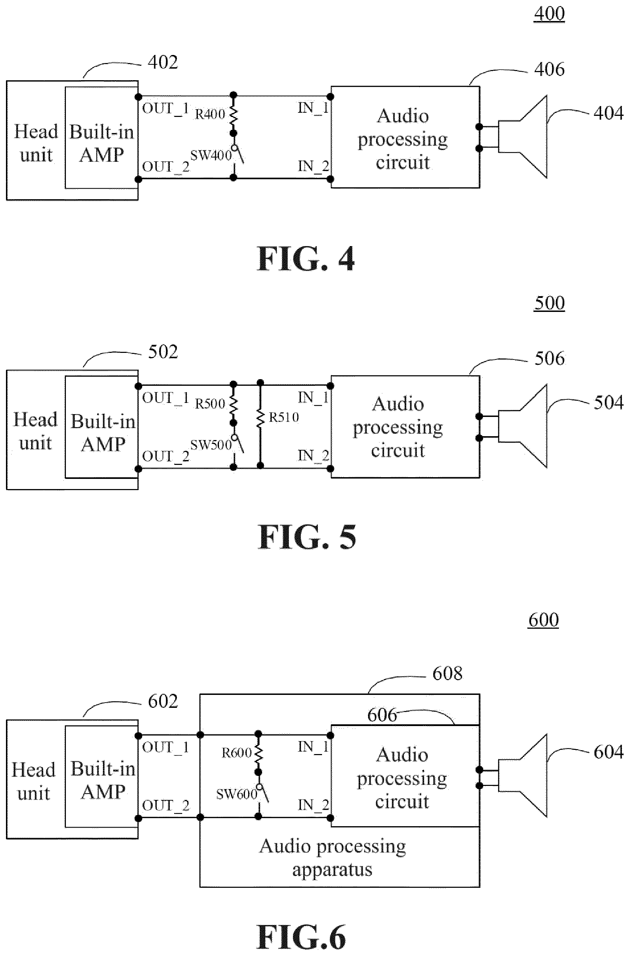

In view of this, the present disclosure further provides an impedance adaptation circuit with power-off capability after completion of the start-up load diagnostic, thereby avoiding unnecessary power consumption and heat generation after the start-up load diagnostic is completed, and effectively reducing the circuit packaging area. An example of the in-vehicle infotainment system with the impedance adaptation circuit according to one or more embodiments of the present disclosure will be described in conjunction with FIG. 4 to FIG. 8.

FIG. 4 is a circuit schematic of a first example of the in-vehicle infotainment system with the impedance adaptation circuit according to an embodiment of the present disclosure. It can be understood that most of the impedance adaptation circuits of FIG. 4 and FIG. 3 are the same. The difference is that: in FIG. 3, the adaptation resistor R300 is connected between the head unit 302 and the audio processing circuit 306, while in FIG. 4, what is connected between a head unit 402 and an audio processing circuit 406 is an impedance adaptation circuit including an adaptation resistor R400 and a switching element SW400.

As shown in FIG. 4, in the in-vehicle infotainment system 400, the head unit 402 can provide a pair of audio signals to a first audio input end IN_1 and a second audio input end IN_2 of the audio processing circuit 406 at a first audio output end OUT_1 and a second audio output end OUT_2. Then, the audio processing circuit 406 may drive a speaker 404 to achieve sound output. In the embodiment of the present disclosure, various types of audio processing circuits 406 can be added to a built-in AMP of the head unit 402 to enhance the performance of the entire in-vehicle audio system. As an illustrative example, the audio processing circuit 406 may be an audio power amplification circuit to enhance the audio driving capability. It can be understood that the audio power amplification circuit can be an ordinary audio power amplifier with enhanced driving characteristics, or a digital audio processor (DSP) power amplifier with a built-in DSP to enhance the equalizer (EQ) performance of the in-vehicle audio system. It should be noted that the present disclosure does not limit the specific type and quantity of the audio processing circuit.

It can be understood that FIG. 4 only depicts one output channel from the head unit 402 to the audio processing circuit 406 and then to the speaker 404, but both the head unit 402 and the audio processing circuit 406 can have more output channels to drive a greater number of speakers, such as the 4-channel configuration shown in FIGS. 1-2. The in-vehicle infotainment system of the embodiments of the present disclosure may also include more or less speakers installed at different locations in the vehicle to achieve sound output of any number of channels, and the impedance adaptation circuit may be adapted to each channel between the head unit 402 and the audio processing circuit 406.

As mentioned above, the impedance adaptation circuit is connected between the head unit 402 and the audio processing circuit 406, and includes the adaptation resistor R400 and the switching element SW400. Specifically, a first end (upper end) of the adaptation resistor R400 is connected to the first audio output end OUT_1 of the head unit 402 and the first audio input end IN_1 of the audio processing circuit 406, a second end (lower end) of the adaptation resistor R400 is connected to a first end (upper end) of the switching element SW400, and a second end (lower end) of the switching element SW400 is connected to the second audio output end OUT_2 of the head unit 402 and the second audio input end IN_2 of the audio processing circuit 406. Similar to what is described with reference to FIG. 3, the adaptation resistor R400 has a resistance value within a matched working impedance range of the head unit 402, and the switching element SW400 is configured to be in an on state during start-up load diagnostic of the head unit 402 and switch off after the start-up load diagnostic is completed. The working principle of the impedance adaptation circuit of the in-vehicle infotainment system will be described specifically below.

When the head unit 402 is just powered on, the start-up load diagnostic process can be run, and at this time, the switching element SW400 is in the on state. Correspondingly, the head unit 402 can calculate a load impedance based on a voltage applied to both ends of the load (that is, a voltage between the first audio output end OUT_1 and the second audio output end OUT_2) and a current flowing through the load, and results of the start-up load diagnostic include one of an open circuit impedance, a short circuit impedance and a matched working impedance. Correspondingly, when there is an open circuit or short circuit abnormality, the head unit 402 will determine that there is an open circuit impedance or a short circuit impedance, and therefore will not provide an audio signal to the audio processing circuit 406, and therefore will not start driving the speaker 404. On the contrary, when the audio processing circuit 406 is correctly connected to the head unit 402, due to the existence of the adaptation resistor R400 (for example, a resistance value of 20 ohms), the head unit 402 will determine that there is a matched working impedance, and therefore start to provide an audio signal to the audio processing circuit 406 to drive the speaker 404. Thereafter, after the start-up load diagnostic is completed (for example, typically a few hundred milliseconds), the switching element SW400 can switch off, so that the impedance adaptation circuit including the adaptation resistor R400 and the switching element SW400 is disconnected from the entire circuit, without drawing power from the first audio output end OUT_1 and the second audio output end OUT_2, so there will be no unnecessary power consumption and heat generation and dissipation problems as mentioned above. In addition, since a voltage value output from the built-in AMP of the head unit 402 during the start-up load diagnostic is low (for example, much lower than 5 Vrms), its consumption of power during the start-up diagnostic will not exceed (5V*5V)/20Ω=1.25W, so that just a small size package specification that can withstand about 1W power needs to be selected for the adaptation resistor R400, thereby effectively reducing the circuit packaging area. Especially in an in-vehicle infotainment system with a multi-channel configuration, by arranging the impedance adaptation circuit in each channel between the head unit and the audio processing circuit, the overall power consumption can be significantly reduced.

It can be understood that in theory, as long as the resistance value of the adaptation resistor R400 is set to be between upper and lower limits of a workload detection threshold of the head unit, the start-up load diagnostic process can be successfully passed. Therefore, the resistance value of the adaptation resistor R400 has a relatively large range of choices. However, when the adaptation resistor R400 is selected to have a small resistance value close to the lower limit of the workload detection threshold of the head unit, according to U²/R, it consumes a lot of power, generates a lot of heat, and requires a large size package specification to withstand high power. In this regard, although multiple resistors with large resistance values can be connected in parallel to achieve an adaptation resistor with a small resistance value in order to reduce the package size of a single resistor, the multiple parallel resistors will also occupy a large packaging area. Preferably, the adaptation resistor R400 is selected to be close to the upper limit of the workload detection threshold of the head unit, thereby reducing power consumption while passing the start-up load detection successfully.

In addition, the inventor realized that the selection of the resistance value of the adaptation resistor R400 should take into account that different types of head units will use different types of built-in AMPs and therefore will have different threshold standards for load diagnostic, so that the compatibility and adaptability of the impedance adaptation circuit to various types of head units should be improved as much as possible. For example, built-in AMPs of head units from different manufacturers can use many different types of power amplification chips, such as NXP TDF8532, TI TAS6424, ST TDA65710, FDA802, etc. However, these chips that are available on the market and used in head units will have different workload detection thresholds (as shown in Table 1). In this case, only when the resistance value of the adaptation resistor R400 is set to be between an upper limit and a lower limit of a workload detection threshold of each type of power amplification chip, will it be regarded as the matched working impedance of the head unit during start-up load diagnostic of various types of head units, without being regarded as abnormal conditions such as short circuits or open circuits. In the embodiment of the present disclosure, the resistance value of the adaptation resistor R400 can be determined based on matched working impedance ranges of multiple different types of head units (such as multiple different types of built-in audio power amplification chips contained therein). In an example of the embodiment of the present disclosure, the resistance value of the adaptation resistor R400 may be selected as a minimum upper limit among upper limits of respective workload detection thresholds of multiple different types of built-in audio power amplification chips.

According to the embodiment of the present disclosure, the impedance adaptation circuit has the power-off capability after completion of the start-up load diagnostic, thereby avoiding unnecessary power consumption and heat generation after the start-up load diagnostic is completed, and effectively reducing the circuit packaging area.

FIG. 5 is a circuit schematic of a second example of an in-vehicle infotainment system with an impedance adaptation circuit according to an embodiment of the present disclosure. It can be understood that most of the impedance adaptation circuits of FIG. 5 and FIG. 4 are the same, and the difference is that FIG. 5 further includes an impedance stabilization resistor R510 connected in parallel with the impedance adaptation circuit including an adaptation resistor R500 and a switching element SW500, the impedance stabilization resistor being used to stabilize an input impedance of a rear-stage audio processing circuit 506 of a head unit 502 when the switching element SW500 of the impedance adaptation circuit switches off, that is, to maintain the high impedance state input impedance stable.

As shown in FIG. 5, similar to the in-vehicle infotainment system 400, in the in-vehicle infotainment system 500, the impedance adaptation circuit includes the adaptation resistor R500 and the switching element SW500. The adaptation resistor R500 has a resistance value within a matched working impedance range of the head unit 502, and the switching element SW500 is configured to be in an on state during start-up load diagnostic of the head unit 502 and switch off after the start-up load diagnostic is completed.

The inventor noticed that when the switching element SW500 is in the on state, an input impedance of a rear-stage circuit of the head unit 502 is approximately a small resistance value (for example, about 20 ohms) of the adaptation resistor R500; and when the switching element SW500 switches off, since a circuit branch where the adaptation resistor R500 is located has been disconnected, the input impedance of the rear-stage circuit of the head unit 502 is completely determined by an input impedance of an added external audio processing circuit 506, so it will experience a transition from a low impedance state input impedance to a high impedance state input impedance. However, since the external audio processing circuit 506 may be various types of audio processing circuits used to enhance the performance of the in-vehicle audio system and therefore there are certain differences in circuit parameters, when the switching element SW500 switches off, there is a certain degree of uncertainty in the impedance change from the low impedance state input impedance to the high impedance state input impedance. In view of this, in order to keep the high impedance state input impedance stable when the switching element in the impedance adaptation circuit switches off, in this example, based on the impedance adaptation circuit including the adaptation resistor R500 and the switching element SW500, the impedance stabilization resistor R510 in parallel with the impedance adaptation circuit (for example, in the range of about 10 kilohms to 22 kilohms) may be further arranged, so that when the switching element SW500 switches off, due to the presence of the resistor R510 with a high resistance value, the high impedance state input impedance remains stable when the impedance adaptation circuit switches off.

FIG. 6 is a circuit schematic of a third example of an in-vehicle infotainment system with an impedance adaptation circuit according to an embodiment of the present disclosure. It can be understood that most of the impedance adaptation circuits of FIG. 6 and FIG. 4 are the same. The difference is that the impedance adaptation circuit including the adaptation resistor R400 and the switching element SW400 and the audio processing circuit 406 in FIG. 4, as a whole, can be seen as an external audio processing apparatus used to enhance the audio driving performance of the head unit 402, but the impedance adaptation circuit and the audio processing circuit 406 are not integrated in the same package, while the impedance adaptation circuit including an adaptation resistor R600 and a switching element SW600 and an audio processing circuit 606 in FIG. 6 are integrated in the same package 608. It can be understood that optionally, similar to what is described with reference to FIG. 5, based on the impedance adaptation circuit including the adaptation resistor R600 and the switching element SW600, an impedance stabilization resistor, e.g., in the range of approximately 10 kilohms to 22 kilohms, connected in parallel with the impedance adaptation circuit may be further arranged in the audio processing apparatus 608, so that the high impedance state input impedance remains stable when the impedance adaptation circuit switches off.

As shown in FIG. 6, in the in-vehicle infotainment system 600, the impedance adaptation circuit with the adaptation resistor R600 and the switching element SW600 and the audio processing circuit 606 are integrated within the package of the audio processing apparatus 608. For example, the impedance adaptation circuit and the audio processing circuit 606 can be packaged in the same apparatus housing and connected to a head unit 602 as an apparatus-level post-installed audio part to enhance its performance. In this embodiment, the impedance adaptation circuit and the audio processing circuit 606 packaged together can be simply connected to the head unit 602 through simple wire connections, thereby realizing apparatus-level post-installation improvements of the head unit 602 to improve the overall performance of the in-vehicle audio system.

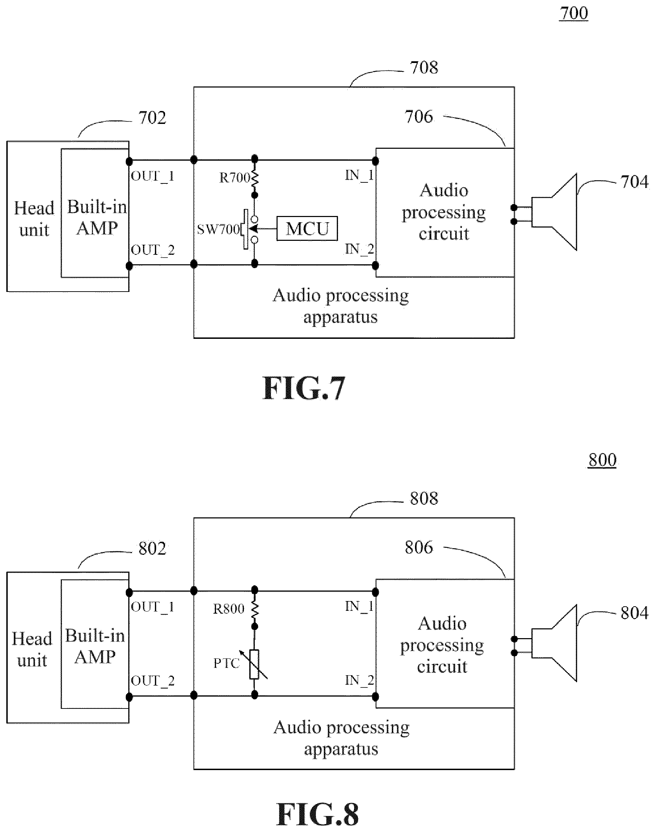

The above describes the examples of the in-vehicle infotainment system with the impedance adaptation circuit according to the embodiments of the present disclosure, and introduces the resistance value selection of the adaptation resistor. In addition, it should be noted that in the embodiments of the present disclosure, multiple types of switches can be used to implement the switching element in the impedance adaptation circuit, as long as they have the ability to switch off after completing the start-up load diagnostic. The present disclosure does not limit the specific type of the switching element. Examples of several implementations of the switching element in the impedance adaptation circuit of the embodiments of the present disclosure will be described below with reference to FIGS. 7 and 8.

FIG. 7 is a circuit schematic of a fourth example of an in-vehicle infotainment system with an impedance adaptation circuit according to an embodiment of the present disclosure. It can be understood that most of the impedance adaptation circuits of FIG. 7 and FIG. 6 are the same, and the difference is that FIG. 7 depicts an example in which a switching element SW700 is implemented as a controlled switching element. It can be understood that optionally, similar to what is described with reference to FIG. 5, based on the impedance adaptation circuit including an adaptation resistor R700 and the switching element SW700, an impedance stabilization resistor, e.g., in the range of approximately 10 kilohms to 22 kilohms, connected in parallel with the impedance adaptation circuit may be further arranged in an audio processing apparatus 708, so that the high impedance state input impedance remains stable when the impedance adaptation circuit switches off.

As shown in FIG. 7, in the in-vehicle infotainment system 700, the switching element SW700 can be implemented as a controlled switching element, which is in an on state during start-up load diagnostic of a head unit 702, and after the start-up load diagnostic is completed, the switch switches off under the control of a microcontroller unit (MCU) to prevent the adaptation resistor R700 from continuing to consume power. In the embodiment of the present disclosure, the controlled switching element can be implemented in various ways. For example, the switching element SW700 can include a relay or a metal oxide semiconductor field effect transistor (MOSFET).

Specifically, as mentioned above, the start-up diagnostic process usually needs to take several hundred milliseconds. Therefore, the MCU can preset a time of several hundred milliseconds (for example, 500 milliseconds) as the action time to control the switch element SW700 to switch off. For example, the MCU can use its internal timer to determine whether the preset action time has elapsed since start-up, and send a control signal to the switching element SW700 after the preset time has elapsed, so that the switching element SW700 switches off under its control. In the embodiment of the present disclosure, the preset action time value for switch-off control can be determined based on the statistics of the time required for the start-up load diagnostic process using different types of built-in AMPs by different types of head units. It can be understood that the action time for controlling the switching off of the switching element SW700 can be set to the maximum time value required for the different types of head units to perform the start-up load diagnostic process.

It can be understood that in the embodiment of the present disclosure, when an audio processing circuit 706 is an ordinary power amplifier without a controller, an additional MCU needs to be added into an audio processing apparatus 708 to switch off the switching element SW700; and when the audio processing circuit 706 is a DSP power amplifier with a built-in DSP, the built-in DSP can be used to control the switching off of the switching element SW700 without adding an additional MCU, thereby saving circuit cost and circuit packaging area.

FIG. 8 is a circuit schematic of a fifth example of an in-vehicle infotainment system with an impedance adaptation circuit according to an embodiment of the present disclosure. It can be understood that most of the impedance adaptation circuits of FIG. 8 and FIG. 6 and FIG. 7 are the same, and the difference is that FIG. 8 depicts an example in which a switching element SW7 is implemented as a positive temperature coefficient (PTC) thermal switch (or called PTC thermal resistor). It can be understood that the PTC switch or the thermal resistor refers to a thermistor whose resistance value increases as the temperature increases, and the present disclosure mainly utilizes the characteristic that its resistance value increases stepwise as the temperature increases to automatically trigger the switching off of the impedance adaptation circuit. In the embodiment of the present disclosure, the impedance adaptation circuit can be implemented using different types of PTC thermistors, such as a ceramic PTC thermistor and a polymer PTC thermistor. It should be noted that the present disclosure does not limit the specific type, material, shape, etc. of the PTC thermal switch or PTC thermal resistor. It can be understood that optionally, similar to what is described with reference to FIG. 5, based on the impedance adaptation circuit including an adaptation resistor R800 and the PTC thermal switch, an impedance stabilization resistor, e.g., in the range of approximately 10 kilohms to 22 kilohms, connected in parallel with the impedance adaptation circuit is further arranged in an audio processing apparatus 808, so that the high impedance state input impedance remains stable when the impedance adaptation circuit switches off.

As shown in FIG. 8, in the in-vehicle infotainment system 800, the impedance adaptation circuit includes the adaptation resistor R800 and the PTC thermal switch PTC connected in series. It can be understood that the PTC thermal switch or PTC thermistor used in the embodiment of the present disclosure is a semiconductor resistor with temperature sensitivity. When the temperature is low, its resistance value is small and will not affect the normal connection of a circuit in which it is located. When the temperature exceeds a certain value, its resistance value increases stepwise as the temperature increases, causing the circuit in which it is located to switch off. The working principle of the impedance adaptation circuit implemented through the PTC switch in the in-vehicle infotainment system will be described specifically below.

When a head unit 802 is just powered on, the start-up load diagnostic process may run. At this time, the temperature of the PTC thermal switch is low and the resistance value is small, so that the circuit where the adaptation resistor R800 and the PTC thermal switch are located is in an on state. At this time, although the adaptation resistor R800 and the PTC thermal switch draw power from a first audio output end OUT_1 and a second audio output end OUT_2 of the head unit 802, a voltage value output from the head unit 802 during the start-up load diagnostic is relatively small, so the temperature and resistance value of the PTC thermal switch do not change significantly, and the impedance adaptation circuit will continue to be in the on state. Thereafter, after the start-up load diagnostic is completed, the head unit 802 may begin to provide an audio signal with a large amplitude (for example, 10 Vrms) to the audio processing circuit 806 to achieve sound output from a speaker. At this time, since the temperature of the PTC thermal switch is directly related to a current flowing through the PTC thermal switch, when the current flowing through the PTC thermal switch exceeds a predetermined value (equivalently, when the temperature of the PTC thermal switch exceeds a predetermined value), its resistance value increases stepwise as the temperature increases, which in turn manifests as the switching off of the PTC thermal switch, causing the impedance adaptation circuit including the adaptation resistor R800 and the PTC thermal switch not continuing to draw power from the head unit 802, thereby reducing power consumption.

As mentioned above, when the current flowing through the PTC thermal switch exceeds the predetermined value, the PTC thermal switch can switch off to cut off the impedance adaptation circuit. The predetermined value is a trip current of the PTC thermal switch. In the embodiment of the present disclosure, an appropriate trip current value can be selected such that the PTC thermal switch can be automatically disconnected after completing the start-up load diagnostic process to avoid unnecessary power consumption. For example, the trip current of the PTC thermal switch may be determined based on a voltage across the first audio output end OUT_1 and the second audio output end OUT_2 of the head unit 802 and the resistance value of the adaptation resistor R800. As an illustrative example, after completing the start-up load diagnostic, the voltage value between the first audio output end OUT_1 and the second audio output end OUT_2 of the head unit 802 may be, for example, 10 Vrms, and the resistance value of the adaptation resistor R800 may be 20 ohms, so the trip current of 0.3 amps can be determined by dividing any suitable voltage value that does not exceed that 10 Vrms (e.g., 6Vrms) by the adaptation resistance value of 20 ohms. Correspondingly, when the head unit 802 provides a low test signal during the start-up load diagnostic, the impedance adaptation circuit can be in the on state, so that the start-up load diagnostic can be successfully passed; and during the period when the speaker starts to be driven after the start-up load diagnostic is completed, once the audio signal output by the head unit 802 exceeds 6 Vrms, it will trigger the PTC thermal switch to act to switch off (for example, within 0.02 seconds), thus causing the impedance adaptation circuit to disconnect and no longer consume power.

According to the embodiment of the present disclosure, the simple and low-cost impedance adaptation circuit is provided. The impedance adaptation circuit has the ability to automatically switch off after completing the start-up load diagnostic, that is, the switching off of the impedance adaptation circuit is automatically triggered through the large current flowing therein without an additional control unit for switching-off control, so the overall size of the impedance adaptation circuit will not be increased. In addition, since the impedance adaptation circuit switches off by using the characteristic that the PTC thermistor changes stepwise as the temperature increases, it will not produce popping sound emit when an analog controlled switch is controlled to switch off.

According to one or more embodiments of the present disclosure, an impedance adaptation circuit is provided, which may be, for example, the impedance adaptation circuit described in conjunction with FIG. 4 including the adaptation resistor R400 and the switching element SW400, the impedance adaptation circuit described in conjunction with FIG. 5 including the adaptation resistor R500 and the switching element SW500, the impedance adaptation circuit described in conjunction with FIG. 6 including the adaptation resistor R600 and the switching element SW600, the impedance adaptation circuit described in conjunction with FIG. 7 including the adaptation resistor R700 and the switching element SW700, or the impedance adaptation circuit described in conjunction with FIG. 8 including the adaptation resistor R800 and the PTC thermal switch. Specifically, the impedance adaptation circuit is used for being connected between a head unit and an audio processing circuit, and includes an adaptation resistor and a switching element. A first end of the adaptation resistor is connected to a first audio output end of the head unit and a first audio input end of the audio processing circuit, a second end of the adaptation resistor is connected to a first end of the switching element, and a second end of the switching element is connected to a second audio output end of the head unit and a second audio input end of the audio processing circuit. In addition, the adaptation resistor has a resistance value within a matched working impedance range of the head unit, and the switching element is configured to be in an on state during start-up load diagnostic of the head unit and switch off after the start-up load diagnostic is completed. For details about the impedance adaptation circuit, please refer to the descriptions in FIGS. 4 to 8, which will not be described again here.

According to one or more embodiments of the present disclosure, an audio processing apparatus is provided, which may be, for example, the audio processing apparatus described in conjunction with FIG. 4 including the impedance adaptation circuit and the audio processing circuit 406, the audio processing apparatus described in conjunction with FIG. 5 including the impedance adaptation circuit and the audio processing circuit 506, the audio processing apparatus 608 described in connection with FIG. 6, the audio processing apparatus 708 described in connection with FIG. 7 and the audio processing apparatus 808 described in connection with FIG. 8. Specifically, the audio apparatus includes the impedance adaptation circuit and the audio processing circuit described in conjunction with FIGS. 4-8 in the present disclosure, and the impedance adaptation circuit is connected between a head unit and the audio processing circuit and includes an adaptation resistor and a switching element. A first end of the adaptation resistor is connected to a first audio output end of the head unit and a first audio input end of the audio processing circuit, a second end of the adaptation resistor is connected to a first end of the switching element, and a second end of the switching element is connected to a second audio output end of the head unit and a second audio input end of the audio processing circuit. In addition, the adaptation resistor has a resistance value within a matched working impedance range of the head unit, and the switching element is configured to be in an on state during start-up load diagnostic of the head unit and switch off after the start-up load diagnostic is completed. For details about the audio processing apparatus, please refer to the descriptions in FIGS. 4 to 8, which will not be described again here.

According to one or more embodiments of the present disclosure, an in-vehicle infotainment system is provided, which may be, for example, the in-vehicle infotainment system described in conjunction with FIGS. 4-8. Specifically, the in-vehicle infotainment system may include a head unit, an impedance adaptation circuit, an audio processing circuit, and a speaker connected to an output of the audio processing circuit described in conjunction with FIGS. 4-8. For specific details about the in-vehicle infotainment system, please refer to the descriptions in FIGS. 4 to 8, which will not be described again here.

The block diagrams of apparatuses, devices, and systems involved in the present disclosure are only exemplary, and are not intended to require or imply that they must be connected, arranged, or configured in the manner shown in the block diagrams. As those skilled in the art will recognize, these circuits, devices, apparatuses, equipment, and systems may be connected, arranged, and configured in any manner as long as the desired purpose is achieved.

The processes and logic flows described in this specification may be performed by one or more programmable processors executing one or more computer programs to perform functions by operating on input data and generating output. The processes and logic flows may also be executed by, and apparatuses may be implemented as, dedicated logic circuits, such as FPGAs (Field Programmable Gate Arrays) or ASICs (Application Specific Integrated Circuits).

Although operations are depicted in a specific order in the figures, this should not be understood as requiring that the operations be performed in the specific order or sequence shown, or that all illustrated operations be performed, to obtain desirable results. In some cases, multitasking and parallel processing may be advantageous.

Certain features described in this specification in the context of separate embodiments may also be combined. Conversely, various features that are described in the context of separate embodiments can also be implemented in multiple embodiments separately or in any suitable sub-combination.

Those skilled in the art should understand that the above-mentioned specific embodiments are only examples and not limitations, and the embodiments of the present disclosure can be variously modified, combined, partially combined and replaced according to design requirements and other factors, as long as they are within the scope of the attached claims, they belong to the scope of rights to be protected by the present disclosure.

## Claims

1. An impedance adaptation circuit, used for being connected between a head unit and an audio processing circuit, wherein
the impedance adaptation circuit comprises an adaptation resistor and a switching element;
a first end of the adaptation resistor is connected to a first audio output end of the head unit and a first audio input end of the audio processing circuit;
a second end of the adaptation resistor is connected to a first end of the switching element;
a second end of the switching element is connected to a second audio output end of the head unit and a second audio input end of the audio processing circuit;
the adaptation resistor has a resistance value within a matched working impedance range of the head unit; and
the switching element is configured to be in an on state during start-up load diagnostic of the head unit and switch off after the start-up load diagnostic is completed.

2. The impedance adaptation circuit according to claim 1, wherein the switching element comprises a relay or a metal oxide semiconductor field effect transistor.

3. The impedance adaptation circuit according to claim 1, wherein the switching element comprises a positive temperature coefficient thermal switch, and the switching element switches off when a current flowing in the positive temperature coefficient thermal switch is greater than a trip current of the positive temperature coefficient thermal switch.

4. The impedance adaptation circuit according to claim 3, wherein the trip current of the positive temperature coefficient thermal switch is determined based on a voltage across the first audio output end and the second audio output end of the head unit and the resistance value of the adaptation resistor.

5. The impedance adaptation circuit according to claim 1, wherein a result of the start-up load diagnostic comprises one of an open circuit impedance, a short circuit impedance, and a matched working impedance.

6. The impedance adaptation circuit according to claim 1, wherein the resistance value of the adaptation resistor is determined based on matched working impedance ranges of a plurality of different types of head units comprising the head unit.

7. An audio processing apparatus, comprising:
the impedance adaptation circuit according to any one of claims 1-6; and
an audio processing circuit.

8. The audio processing apparatus according to claim 7, wherein the impedance adaptation circuit and the audio processing circuit are integrated in the same package.

9. The audio processing apparatus according to claim 7, further comprising an impedance stabilization resistor connected in parallel with the impedance adaptation circuit, the impedance stabilization resistor being used for stabilizing an input impedance of the audio processing circuit when the switching element of the impedance adaptation circuit switches off.

10. An in-vehicle infotainment system, comprising:
a head unit;
the impedance adaptation circuit according to any one of claims 1-6;
an audio processing circuit; and
a speaker, connected to an output of the audio processing circuit.

## Patentansprüche

1. Impedanzanpassungsschaltung, die verwendet wird, um zwischen einer Haupteinheit und einer Audioverarbeitungsschaltung verbunden zu sein, wobei
die Impedanzanpassungsschaltung einen Anpassungswiderstand und ein Schaltelement umfasst;
ein erstes Ende des Anpassungswiderstandes mit einem ersten Audioausgangsende der Haupteinheit und einem ersten Audioeingangsende der Audioverarbeitungsschaltung verbunden ist;
ein zweites Ende des Anpassungswiderstands mit einem ersten Ende des Schaltelements verbunden ist;
ein zweites Ende des Schaltelements mit einem zweiten Audioausgangsende der Haupteinheit und einem zweiten Audioeingangsende der Audioverarbeitungsschaltung verbunden ist;
der Anpassungswiderstand einen Widerstandswert innerhalb eines abgestimmten Arbeitsimpedanzbereichs der Haupteinheit hat; und das Schaltelement konfiguriert ist, um während der Startlastdiagnose der Haupteinheit in einem eingeschalteten Zustand und, nachdem die Startlastdiagnose abgeschlossen ist, ausgeschaltet zu sein.

2. Impedanzanpassungsschaltung nach Anspruch 1, wobei das Schaltelement ein Relais oder einen Metall-Oxid-Halbleiter-Feldeffekttransistor umfasst.

3. Impedanzanpassungsschaltung nach Anspruch 1, wobei das Schaltelement einen Thermoschalter mit positivem Temperaturkoeffizienten umfasst und das Schaltelement abschaltet, wenn ein Strom, der in dem Thermoschalter mit positivem Temperaturkoeffizienten fließt, größer ist als ein Auslösestrom des Thermoschalters mit positivem Temperaturkoeffizienten.

4. Impedanzanpassungsschaltung nach Anspruch 3, wobei der Auslösestrom des Thermoschalters mit positivem Temperaturkoeffizienten basierend auf einer Spannung über dem ersten Audioausgangsende und dem zweiten Audioausgangsende der Haupteinheit und dem Widerstandswert des Anpassungswiderstands bestimmt wird.

5. Impedanzanpassungsschaltung nach Anspruch 1, wobei ein Ergebnis der Startlastdiagnose eines von einer Leerlaufimpedanz, einer Kurzschlussimpedanz oder einer abgestimmten Arbeitsimpedanz umfasst.

6. Impedanzanpassungsschaltung nach Anspruch 1, wobei der Widerstandswert des Anpassungswiderstandes basierend auf abgestimmten Arbeitsimpedanzbereichen einer Vielzahl von verschiedenen Typen von Haupteinheiten, umfassend die Haupteinheit, bestimmt wird.

7. Audioverarbeitungsvorrichtung, umfassend:
die Impedanzanpassungsschaltung nach einem der Ansprüche 1 bis 6; und
eine Audioverarbeitungsschaltung.

8. Audioverarbeitungsvorrichtung nach Anspruch 7, wobei die Impedanzanpassungsschaltung und die Audioverarbeitungsschaltung in demselben Gehäuse integriert sind.

9. Audioverarbeitungsvorrichtung nach Anspruch 7, ferner umfassend einen Impedanzstabilisierungswiderstand, der parallel zu der Impedanzanpassungsschaltung verbunden ist, wobei der Impedanzstabilisierungswiderstand zum Stabilisieren einer Eingangsimpedanz der Audioverarbeitungsschaltung verwendet wird, wenn das Schaltelement der Impedanzanpassungsschaltung abschaltet.

10. Fahrzeuginternes Infotainmentsystem, umfassend:
eine Haupteinheit;
die Impedanzanpassungsschaltung nach einem der Ansprüche 1 bis 6;
eine Audioverarbeitungsschaltung; und
einen Lautsprecher, der mit einem Ausgang der Audioverarbeitungsschaltung verbunden ist.

## Revendications

1. Circuit d'adaptation d'impédance, utilisé pour être connecté entre une unité principale et un circuit de traitement audio, dans lequel
le circuit d'adaptation d'impédance comprend une résistance d'adaptation et un élément de commutation ;
une première extrémité de la résistance d'adaptation est connectée à une première extrémité de sortie audio de l'unité principale et à une première extrémité d'entrée audio du circuit de traitement audio ;
une seconde extrémité de la résistance d'adaptation est connectée à une première extrémité de l'élément de commutation ;
une seconde extrémité de l'élément de commutation est connectée à une seconde extrémité de sortie audio de l'unité principale et à une seconde extrémité d'entrée audio du circuit de traitement audio ;
la résistance d'adaptation présente une valeur de résistance située dans une plage d'impédance de fonctionnement adaptée de l'unité principale ; et
l'élément de commutation est configuré pour être dans un état activé pendant le diagnostic de charge de démarrage de l'unité principale et s'éteindre une fois le diagnostic de charge de démarrage terminé.

2. Circuit d'adaptation d'impédance selon la revendication 1, dans lequel l'élément de commutation comprend un relais ou un transistor à effet de champ métal oxyde semi-conducteur.

3. Circuit d'adaptation d'impédance selon la revendication 1, dans lequel l'élément de commutation comprend un commutateur thermique à coefficient de température positif, et l'élément de commutation se désactive lorsqu'un courant circulant dans le commutateur thermique à coefficient de température positif est supérieur à un courant de déclenchement du commutateur thermique à coefficient de température positif.

4. Circuit d'adaptation d'impédance selon la revendication **3,** dans lequel le courant de déclenchement du commutateur thermique à coefficient de température positif est déterminé sur la base d'une tension aux bornes de la première extrémité de sortie audio et de la seconde extrémité de sortie audio de l'unité principale et de la valeur de résistance de la résistance d'adaptation.

5. Circuit d'adaptation d'impédance selon la revendication **1,** dans lequel un résultat du diagnostic de charge de démarrage comprend une d'une impédance de circuit ouvert, d'une impédance de court-circuit, et d'une impédance de fonctionnement adaptée.

6. Circuit d'adaptation d'impédance selon la revendication **1,** dans lequel la valeur de résistance de la résistance d'adaptation est déterminée sur la base de plages d'impédance de fonctionnement adaptées d'une pluralité de types différents d'unités principales comprenant l'unité principale.

7. Appareil de traitement audio, comprenant :
le circuit d'adaptation d'impédance selon l'une quelconque des revendications 1 à 6 ; et
un circuit de traitement audio.

8. Appareil de traitement audio selon la revendication 7, dans lequel le circuit d'adaptation d'impédance et le circuit de traitement audio sont intégrés dans le même boîtier.

9. Appareil de traitement audio selon la revendication 7, comprenant également une résistance de stabilisation d'impédance connectée en parallèle avec le circuit d'adaptation d'impédance, la résistance de stabilisation d'impédance étant utilisée pour stabiliser une impédance d'entrée du circuit de traitement audio lorsque l'élément de commutation du circuit d'adaptation d'impédance s'éteint.

10. Système d'infodivertissement embarqué, comprenant :
une unité principale ;
le circuit d'adaptation d'impédance selon l'une quelconque des revendications 1 à 6 ;
un circuit de traitement audio ; et
un haut-parleur, connecté à une sortie du circuit de traitement audio.
